# EUROPEAN PATENT APPLICATION

(11) **EP 4 174 538 A1**
(43) Date of publication of application: **03.05.2023**
(21) Application number: 21828020.4
(22) Date of filing: 07.06.2021
(51) Int. Cl.: G02B 6/12, G02B 6/32, G02B 6/42

(54) **OPTICAL WAVEGUIDE PACKAGE, LIGHT-EMITTING DEVICE, AND PROJECTION SYSTEM**

(30) Priority: 26.06.2020 JP 2020110903
(71) Applicant: Kyocera Corporation, Kyoto-shi Kyoto 612-8501 (JP)
(72) Inventor: SHODA, Michifumi, Kyoto-shi, Kyoto 612-8501 (JP); FUJIMOTO, Yasuhiro, Kyoto-shi, Kyoto 612-8501 (JP)
(74) Representative: Viering, Jentschura & Partner mbB Patent- und Rechtsanwälte
(86) International application number: PCT/JP2021/021545
(87) International publication number: WO 2021/261232

(57) **Abstract**

An optical waveguide package includes a substrate including a first surface, a cladding on the first surface, a core in the cladding, and a lens on an optical path of light emitted from the core. Light emitted from a first element enters a first core through a first end and is output through a second end. Light emitted from a second element enters a second core through a third end and is output through a fourth end. The second end and the lens are at a first distance corresponding to a wavelength of the light from the first element, and the fourth end and the lens are at a second distance corresponding to a wavelength of the light from the second element.

## Description

### TECHNICAL FIELD

The present disclosure relates to an optical waveguide package, a light emitter, and a projection system.

### BACKGROUND OF INVENTION

A known technique is described in, for example, Patent Literature 1.

### CITATION LIST

### PATENT LITERATURE

Patent Literature 1: Japanese Unexamined Patent Application Publication No. 2018-189906

### SUMMARY

In an aspect of the present disclosure, an optical waveguide package includes a substrate including a first surface, a cladding on the first surface, a first core including a first end to receive light from a first element and a second end opposite to the first end, a second core including a third end to receive light from a second element having a wavelength of light different from a wavelength of light from the first element, and a fourth end opposite to the third end, and a lens on an optical path of light emitted through the second end and through the fourth end. The second end and the lens are at a first distance corresponding to the wavelength of the light from the first element. The fourth end and the lens are at a second distance corresponding to the wavelength of the light from the second element.

In another aspect of the present disclosure, a light emitter includes the above optical waveguide package, a first element, and a second element.

In still another aspect of the present disclosure, a projection system includes the above light emitter, and a screen on an optical path of light condensed by the lens.

### BRIEF DESCRIPTION OF THE DRAWINGS

The objects, features, and advantages of the present disclosure will become more apparent from the following detailed description and the drawings.
FIG. 1 is an exploded perspective view of a light emitter including an optical waveguide package according to an embodiment of the present disclosure.
FIG. 2 is a perspective view of the light emitter in FIG. 1 without illustrating a sealing lid.
FIG. 3 is a cross-sectional view of the light emitter taken along section line III-III in FIG. 2.
FIG. 4 is a plan view of the light emitter.
FIG. 5 is an enlarged plan view of a light emitter according to another embodiment of the present disclosure, illustrating a portion adjacent to a lens.
FIG. 6A is an enlarged plan view of a light emitter according to still another embodiment of the present disclosure, illustrating a portion adjacent to the lens.
FIG. 6B is an enlarged side view of the light emitter, illustrating a portion adjacent to the lens.
FIG. 7 is an enlarged perspective view of a light emitter according to still another embodiment of the present disclosure, illustrating a portion adjacent to the lens.
FIG. 8 is an enlarged plan view of a light emitter according to still another embodiment of the present disclosure, illustrating a portion adjacent to the lens.
FIG. 9 is an exploded perspective view of a light emitter according to still another embodiment of the present disclosure.
FIG. 10 is a perspective view of the light emitter in FIG. 9 without illustrating a sealing lid.
FIG. 11 is a cross-sectional view of the light emitter taken along section line XI-XI in FIG. 9.
FIG. 12 is a schematic diagram of a projection system according to an embodiment of the present disclosure.

### DESCRIPTION OF EMBODIMENTS

In the structure that forms the basis of an image projection device according to one or more embodiments of the present disclosure, light beams emitted from multiple light sources pass through the respective optical waveguides, are condensed through a condensing lens, are reflected from a scanning mirror, and are projected onto a screen.

A light emitter according to one or more embodiments of the present disclosure will now be described with reference to the accompanying drawings.

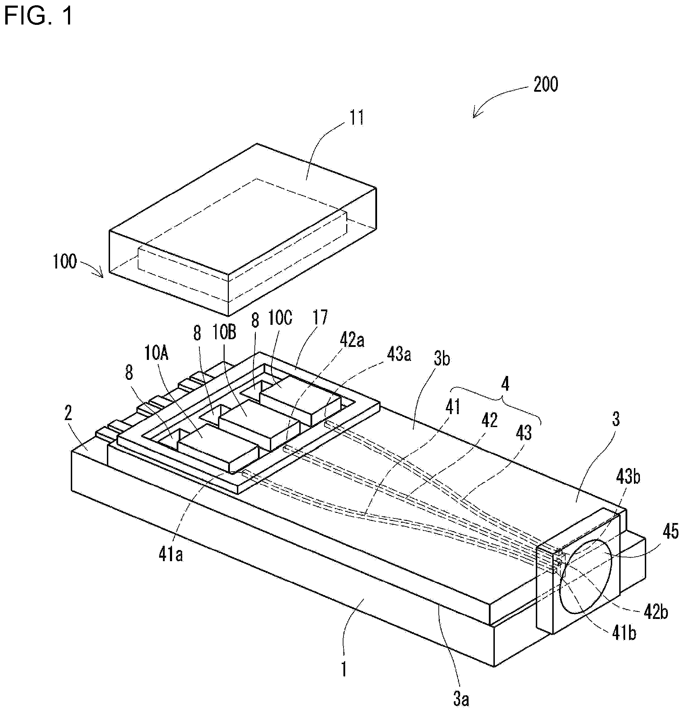

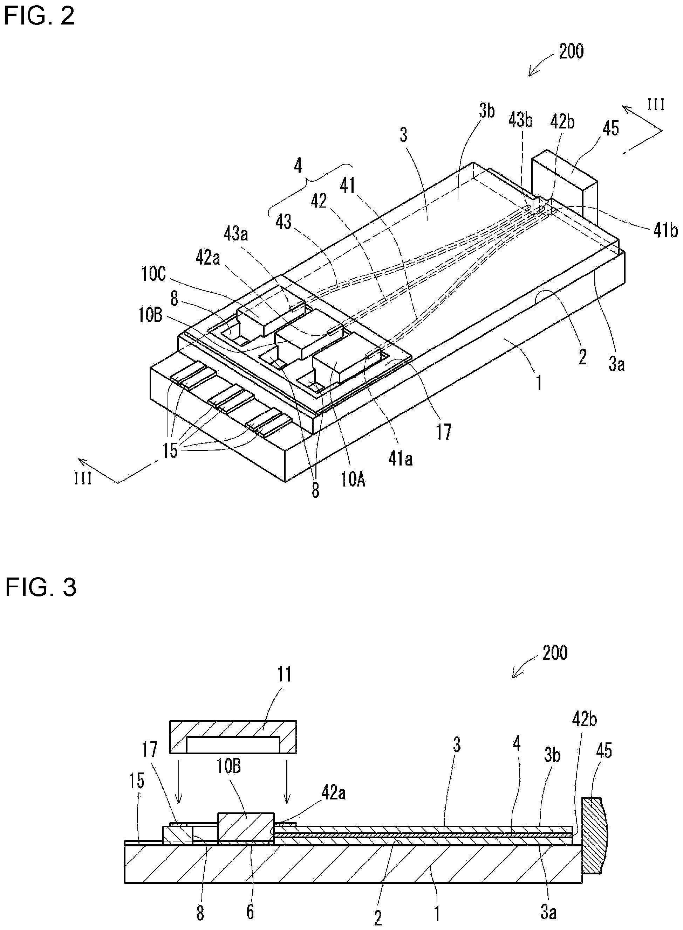

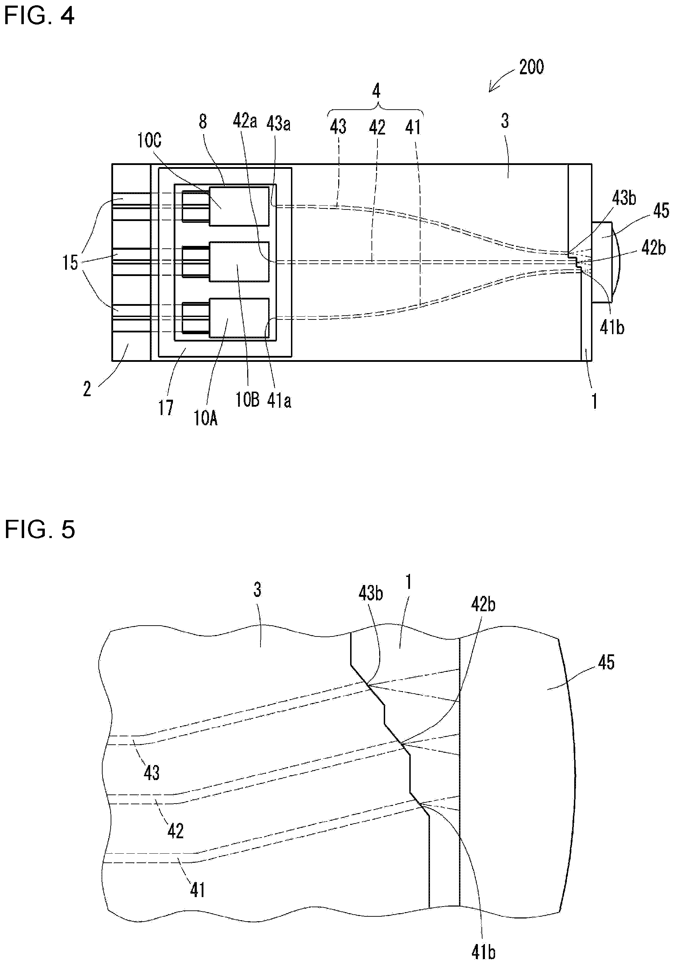

FIG. 1 is an exploded perspective view of a light emitter 200 including an optical waveguide package 100 according to an embodiment of the present disclosure. FIG. 2 is a perspective view of the light emitter 200 in FIG. 1 without illustrating a sealing lid 11. FIG. 3 is a cross-sectional view of the light emitter 200 taken along section line III-III in FIG. 2. FIG. 4 is a plan view of the light emitter 200. The optical waveguide package 100 according to the present embodiment includes a substrate 1 including a first surface 2, a cladding 3 located on the first surface 2, a core 4 located in the cladding 3, and a lens 45 located on an optical path of light emitted from the core 4.

In the embodiment described in FIGs. 1 to 4, the optical waveguide package 100 includes through-holes 8 for accommodating a first element 10A and a second element 10B that are light-emitting elements. The light emitter 200 includes the optical waveguide package 100 and the first and second elements 10A and 10B. In the present embodiment, the optical waveguide package 100 further includes a through-hole 8 for accommodating a third element 10C that is a light-emitting element. The light emitter 200 includes the third element 10C. In the embodiment of the present disclosure, the optical waveguide package 100 includes the third element 10C, but is not limited to this structure and may include, for example, the first element 10A and the second element 10B alone. The light-emitting elements may be laser diodes. The substrate 1 includes element mounts 6 in areas defined by the through-holes 8 in the first surface 2. The cladding 3 may include a second surface 3a facing the first surface 2 of the substrate 1, and a third surface 3b opposite to the second surface 3a. The through-holes 8 may extend from the third surface 3b to the second surface 3a.

The element mounts 6 join the light-emitting elements 10A, 10B, and 10C to the first surface 2 of the substrate 1. The element mounts 6 may include, for example, metal members such as metallized layers on the first surface 2 of the substrate 1. The metal members in the element mounts 6 may be joined to the light-emitting elements 10A, 10B, and 10C with a die bonding material such as a brazing material or an adhesive. In the present embodiment, the metal members in the element mounts 6 are connected to external wires 15. The light-emitting elements 10A, 10B, and 10C include electrodes on their lower surfaces electrically connectable to the metal members in the element mounts 6 and further to, for example, an external power circuit through the external wires 15. The external wires 15 may extend from inside the through-holes 8 to outside the through-holes 8. The light-emitting elements 10A, 10B, and 10C include electrodes on their upper surfaces that may be electrically connected to the external wires 15 (not connected to the metal members in the element mounts 6) with, for example, bonding wires (not illustrated). In the present embodiment, the multiple through-holes 8 and the multiple element mounts 6 are equally spaced in a direction perpendicular to the direction in which light is emitted, but are not limited to this structure. The multiple through-holes 8 and the multiple element mounts 6 may be located differently from the arrangement in the present embodiment and may be located, for example, at different levels in a plan view toward the third surface 3b.

In the present embodiment, light emitted from the first element 10A and light emitted from the second element 10B have different wavelengths. In the present embodiment, light emitted from the first element 10A and light emitted from the second element 10B have wavelengths different from the wavelength of light emitted from the third element 10C. For example, light emitted from the first element 10A is blue light (wavelength λB = 450 nm), and light emitted from the second element 10B is green light (wavelength λG = 520 nm). Light emitted from the third element 10C is, for example, red light (wavelength λR = 650 nm).

The substrate 1 may include multiple dielectric layers stacked on one another. The substrate 1 may be a ceramic wiring board including dielectric layers containing a ceramic material. Examples of the ceramic material used for the ceramic wiring board include sintered aluminum oxide, sintered mullite, sintered silicon carbide, sintered aluminum nitride, and sintered glass ceramic. For the substrate 1 being a ceramic wiring board, the dielectric layers may include conductors such as connection pads, internal wiring conductors, and external connection terminals for electrical connection between the light-emitting and light-receiving elements and an external circuit.

The substrate 1 may be an organic wiring board including dielectric layers containing an organic material. The organic wiring board may be a printed wiring board, a build-up wiring board, or a flexible wiring board. Examples of the organic material used for the organic wiring board include an epoxy resin, a polyimide resin, a polyester resin, an acrylic resin, a phenolic resin, and a fluororesin. The substrate 1 may be a substrate using, for example, a compound semiconductor. Examples of the material used for the substrate using a compound semiconductor include silicon (Si), germanium (Ge), gallium (Ga), arsenic (As), indium (In), phosphorus (P), and sapphire (Al₂O₃).

The cladding 3 and the core 4 may be made of glass such as quartz, or a resin. Both the cladding 3 and the core 4 may be made of glass or a resin. In some embodiments, one of the cladding 3 and the core 4 may be made of glass, and the other may be made of a resin. The core 4 and the cladding 3 may have different refractive indexes, or specifically, the core 4 has a higher refractive index than the cladding 3. The light traveling through the core 4 is fully reflected at the interfaces with the cladding 3 due to this difference in the refractive index. More specifically, a material with a higher refractive index is used to form a path, which is then surrounded by a material with a lower refractive index. This structure confines light in the core 4 with the higher refractive index and allows the light to travel.

The core 4 includes a first core 41 corresponding to the first element 10A and a second core 42 corresponding the second element 10B. The core 4 further includes a third core 43 corresponding to the third element 10C. The first core 41 has a first end 41a to receive light from the first element 10A, and a second end 41b opposite to the first end 41a. The second core 42 has a third end 42a to receive light from the second element 10B, and a fourth end 42b opposite to the third end 42a. The third core 43 has a fifth end 43a to receive light from the third element 10C, and a sixth end 43b opposite to the fifth end 43a.

The blue light emitted from the first element 10A enters the first core 41 through the first end 41a, travels through the first core 41, and is output through the second end 41b. The green light emitted from the second element 10B enters the second core 42 through the third end 42a, travels through the second core 42, and is output through the fourth end 42b. The red light emitted from the third element 10C enters the third core 43 through the fifth end 43a, travels through the third core 43, and is output through the sixth end 43b. In the present embodiment, both the second end 41b of the first core 41 and the fourth end 42b of the second core 42 are exposed at the end face of the cladding 3. The sixth end 43b of the third core 43 is also exposed at the end face of the cladding 3.

The lens 45 is located on the optical path of light emitted through each of the second end 41b and the fourth end 42b, and on the optical path of light emitted through the sixth end 43b. A first distance d1 between the second end 41b and the lens 45 is determined based on the wavelength of light from the first element 10A. A second distance d2 between the fourth end 42b and the lens 45 is determined based on the wavelength of light from the second element 10B. A third distance d3 between the sixth end 43b and the lens 45 is determined based on the wavelength of light from the third element 10C. The wavelength λB of blue light emitted from the first element 10A, the wavelength λG of green light emitted from the second element 10B, and the wavelength λR of red light emitted from the third element 10C have the relationship of λB < λG < λR. The first distance d1, the second distance d2, and the third distance d3 are determined based on the respective wavelengths and the wavelength dependency of the lens 45, and may have the relationship of d1 < d2 < d3.

The lens 45 may be, for example, a condenser lens with a flat incident surface and a convex emission surface. The first distance d1, the second distance d2, and the third distance d3 are determined based on the respective wavelengths, and may also be, for example, longer than or equal to but close to the focal length of light from each end at the lens 45. The focal length at the lens 45 on the incident end varies with the wavelength of the light and may be d1 = F1, d2 = F2, and d3 = F3 (F1 < F2 < F3), where F1 is the focal length of the light with the wavelength λB, F2 is the focal length of the light with the wavelength λG, and F3 is the focal length of the light with the wavelength λR.

The light emitter 200 according to the present embodiment can be used as a light source for a projection system, as described later. The light emitted from the light emitter 200 (light passing through the lens 45) is reflected from a reflecting mirror and irradiated onto the screen. The light passing through the lens 45 is condensed by the lens 45 and once narrowed and spread again. When the screen is located at the position of a beam waist that is the narrowed part of the light, a sharp image without blurring can be obtained. The distance from the lens 45 to the beam waist varies depending on the distance from the lens 45 to the output end of the core 4. When the distance from the lens 45 to the output end of the core 4 is longer than the focal length, the distance from the lens 45 to the beam waist is longer. The distance between the lens 45 and the output end of the core 4 may be set in response to the distance from the lens 45 to the screen. When the light emitter 200 is used as a light source for a projection system, the first distance d1, the second distance d2, and the third distance d3 may have the relationship of d1 > F1, d2 > F2, and d3 > F3. The screen may be set to locate at the position of the beam waist. The distances of the first distance d1, the second distance d2, and the third distance d3 are not equal to the focal length of the lens 45, but have the relationship of d1 < d2 < d3, and correspond to the wavelength of the light.

In the present embodiment, with the first distance d1, the second distance d2, and the third distance d3 different as described above, for example, as illustrated in FIG. 4, the end face of the emission end of the cladding 3 is stepped in a plan view in response to the positions of the second end 41b, the fourth end 42b, and the sixth end 43b. Light with reduced chromatic aberration can be emitted by setting the first distance d1 to the distance in response to the wavelength of the light from the first element 10A, setting the second distance d2 to the distance in response to the wavelength of the light from the second element 10B, and setting the third distance d3 to the distance in response to the wavelength of the light from the third element 10C as described above.

The spacing between the first core 41, the second core 42, and the third core 43 on the incident end corresponds to the spacing between the first element 10A, the second element 10B, and the third element 10C. In the present embodiment, for example, the first core 41, the second core 42, and the third core 43 are equally spaced, but are not limited to this structure. To allow all the light to enter the lens 45, the spacing between the first core 41, the second core 42, and the third core 43 on the output end is narrower than the spacing on the output end. The first core 41, the second core 42, and the third core 43 on the output end are equally spaced in the present embodiment, but are not limited to this structure. In the present embodiment, the first element 10A, the second element 10B, and the third element 10C may be incorporated in the optical waveguide package 100 in the order of wavelength.

The sealing lid 11 covering the through-holes 8 is on the third surface 3b of the cladding 3. A seal ring 17 is located between the sealing lid 11 and the cladding 3. The seal ring 17 is made of a metal material and, for example, in a continuous loop surrounding the through-holes 8. The seal ring 17 improves airtightness in the space accommodating the light-emitting elements 10A, 10B, and 10C (the space defined by the first surface 2 of the substrate 1, the through-holes 8, and the sealing lid 11). The sealing lid 11 may be joined to the cladding 3 with heat. This may cause stress and deform the cladding 3 and the core 4, possibly causing misalignment of the optical axis between each of the light-emitting elements 10A, 10B, and 10C and the core 4. The seal ring 17 surrounding the through-holes 8 improves the mechanical strength around the through-holes 8, reducing deformation of the cladding 3 and the core 4. Thus, the misalignment of the optical axis between each of the light-emitting elements 10A, 10B, 10C and the core 4 is reduced. The optical waveguide package 100 with this structure has high optical transmission efficiency.

The sealing lid 11 may be made of a glass material such as quartz, borosilicate, or sapphire. For example, the seal ring 17 is made of Ti, Ni, Au, Pt, or Cr, or two or more of these metals, and is fixed on the third surface 3b of the cladding 3 by vapor deposition, sputtering, ion plating, or plating. The sealing lid 11 is joined to the seal ring 17 by thermal curing or laser welding using a bond, such as Au-Sn or Sn-Ag-Cu solder, a metal nanoparticle paste of Ag or Cu, or a glass paste.

The seal ring 17 may be located on the sealing lid 11, rather than on the cladding 3, in an area facing the cladding 3. In this case, the seal ring 17 may be made of Ti, Ni, Au, Pt, or Cr, or two or more of these metals, and may be fixed on the sealing lid 11 by vapor deposition, sputtering, ion plating, or plating. The cladding 3 is joined to the seal ring 17 by thermal curing or laser welding using a bond, such as Au-Sn or Sn-Ag-Cu solder, a metal nanoparticle paste of Ag or Cu, or a glass paste.

The seal ring 17 may be located on each of the cladding 3 and the sealing lid 11. In this case, the seal ring 17 on the cladding 3 is joined to the seal ring 17 on the sealing lid 11 by, for example, thermal curing or laser welding using a bond, such as Au-Sn or Sn-Ag-Cu solder, a metal nanoparticle paste of Ag or Cu, or a glass paste.

FIG. 5 is an enlarged plan view of a light emitter according to another embodiment of the present disclosure, illustrating a portion adjacent to the lens 45. The components corresponding to those in the above embodiment are given the same reference numerals and will not be described repeatedly. In the present embodiment, at least one of the end face including the second end 41b or the end face including the fourth end 42b is inclined with respect to the optical path of the light emitted through the second end 41b and the fourth end 42b. The second end 41b that is the output end of the first core 41 is inclined with respect to the optical axis of the first core 41 on the emission end. The optical path of the light emitted through the second end 41b and the optical axis of the first core 41 on the emission end form an angle in response to the refractive index of the first core 41. To cause the optical path of the light emitted through the second end 41b to be parallel to the optical axis of the lens 45, the second end 41b and the end face of the cladding 3 including the second end 41b may be inclined with respect to the optical axis of the lens 45 in response to the refractive index of the first core 41.

A part of the light transmitted through the first core 41 may be reflected at the second end 41b. This reflected light may recombine to the first core 41, travel through the first core 41, and be emitted through the first end 41a. The first element 10A may be illuminated with the reflected light. The light illumination to the first element 10A may fluctuate light emitted from the first element 10A and cause an unstable output. The second end 41b inclined with respect to the optical path of light emitted through the second end 41b as described above reduces the recombination of light reflected at the second end 41b to the first core 41. The light reflected from the lens 45 to the first element 10A can be reduced, thus stabilizing the output from the first element 10A. This applies to the second core 42 and the fourth end 42b. This applies to the third core 43 and the sixth end 43b.

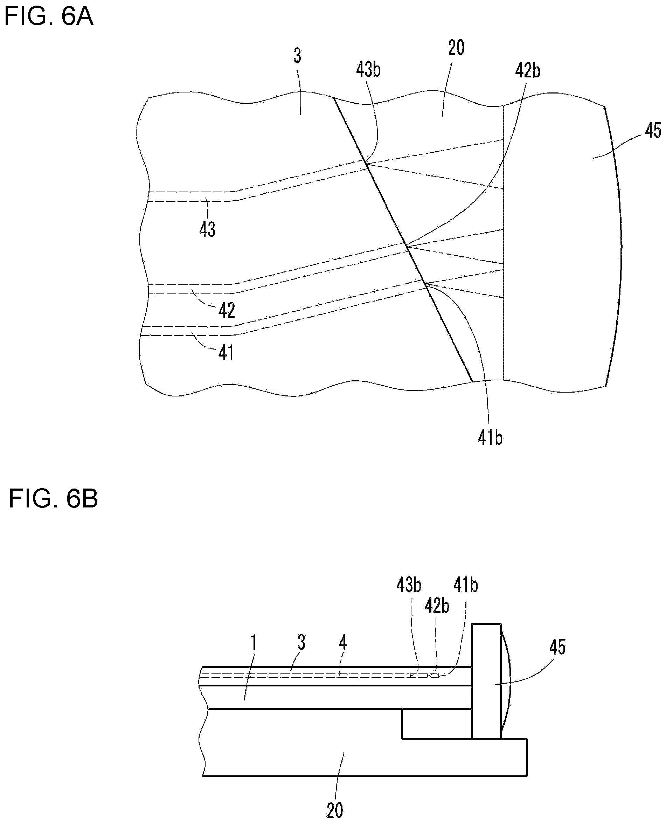

FIG. 6A is an enlarged plan view of a light emitter according to still another embodiment of the present disclosure, illustrating a portion adjacent to the lens 45. FIG. 6B is its enlarged side view. The components corresponding to those in the above embodiments are given the same reference numerals and will not be described repeatedly. In the present embodiment, the cladding 3 includes a flat surface including the second end 41b and the fourth end 42b. In the above embodiments, the end face of the emission end of the cladding 3 is stepped with the end face including the second end 41b, the end face including the fourth end 42b, and the end face including the sixth end 43b. In contrast, the end face on the emission end of the cladding 3 in the present embodiment includes a surface flush with the flat surface including the second end 41b and the fourth end 42b. The flat surface further includes the sixth end 43b. Each of the second and fourth ends 41b and 42b and the sixth end 43b may be inclined with respect to an optical path of light emitted through the end. The end face on the emission end of the cladding 3 is a single flat surface inclined with respect to the optical axis of the lens 45.

The first distance d1, the second distance d2, and the third distance d3 are determined based on the respective wavelengths. For example, the difference between the first distance d1 and the second distance d2 is different from the difference between the second distance d2 and the third distance d3. To include the second and fourth ends 41b and 42b and the sixth end 43b in a surface flush with one another, the first and the second cores 41 and 42 and the third core 43 on the emission end may not be equally spaced, but may be spaced as appropriate for the distances of the first distance d1, the second distance d2, and the third distance d3. In the present embodiment, for example, the spacing between the second core 42 and the third core 43 is larger than the spacing between the first core 41 and the second core 42.

In the present embodiment, the substrate 1 includes a surface flush with the flat surface that is the emission end face of the cladding 3. The emission end face of the substrate 1 and the emission end face of the cladding 3 are flush with each other. This structure can be easily formed by, for example, cutting the substrate 1 and the cladding 3 together on the emission end. This cutting face is the surface including the emission end face of the substrate 1 and the emission end face of the cladding 3 flush with each other. In the above embodiments, the emission end face of the substrate 1 is located closer to the lens 45 than the emission end face of the cladding 3. The lens 45 is, for example, fixed at the emission end face of the substrate 1 to define a space between the lens 45 and the emission end face of the cladding 3. A part of light emitted from the core 4 may be reflected from the first surface 2 of the substrate 1 located ahead of the emission end face of the cladding 3. A part of the light reflected from the first surface 2 does not enter the lens 45, thus reducing the utilization efficiency of the light. The light reflected from the first surface 2 can be noise through the lens 45, thus reducing the image quality. In the structure according to the present embodiment, the first surface 2 of the substrate 1 is not exposed ahead of the output end of the core 4, allowing light emitted from the core 4 to enter the lens 45 without being reflected. Thus, the optical waveguide package 100 according to the present embodiment has high output and high image quality. In the present embodiment, the first element 10A, the second element 10B, and the third element 10C are incorporated in the optical waveguide package 100 in the order of wavelength.

In the above embodiments, to reduce reflection on the first surface 2 of the substrate 1, the distance between the core 4 and the first surface 2 may be increased. Without light emitted from the core 4 being reflected from the first surface 2 of the substrate 1 in the present embodiment, the distance between the core 4 and the first surface 2 can be decreased. In other words, the thickness of the lower part of the cladding 3 below the core 4 can be thinner. Thus, the time taken to form the cladding 3 (film deposition time) can be reduced.

In the present embodiment, with the emission end face of the substrate 1 being inclined, a holding substrate 20 may be located below the substrate 1, without the lens 45 fixed to the substrate 1. The holding substrate 20 includes at least a portion extending beyond the emission end face of the substrate 1. The optical waveguide package 100 may be held on the holding substrate 20, and the lens 45 may be fixed to the extending portion. The holding substrate 20 may be made of a ceramic material. Examples of the ceramic material include sintered aluminum oxide, sintered mullite, sintered silicon carbide, sintered aluminum nitride, and sintered glass ceramic. The holding member 20 may also be made of a metal material. Examples of the metal material include stainless steel and aluminum.

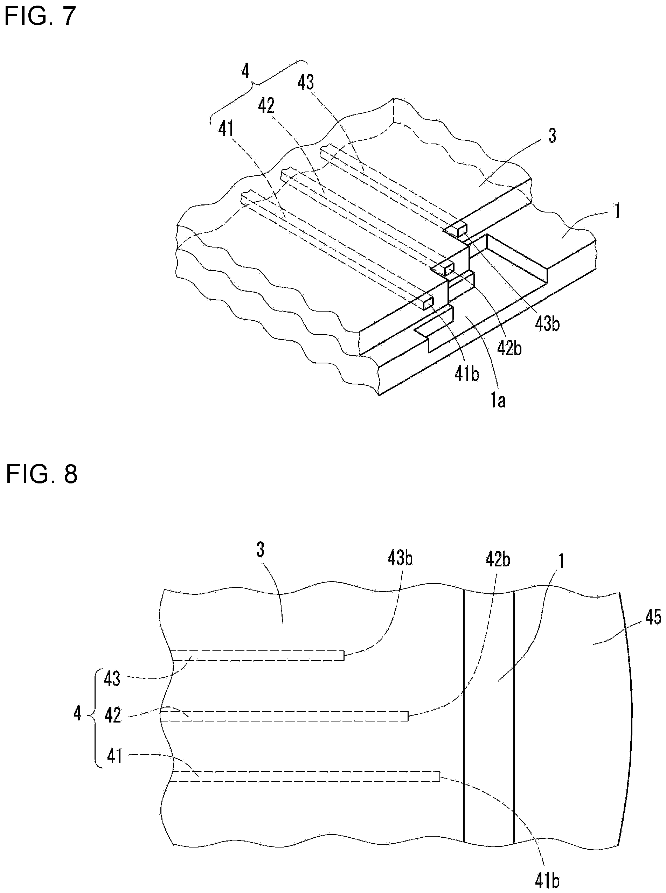

FIG. 7 is an enlarged perspective view of a light emitter according to still another embodiment of the present disclosure, illustrating a portion adjacent to the lens. The components corresponding to those in the above embodiments are given the same reference numerals and will not be described repeatedly. In the present embodiment, the substrate 1 includes a cutout 1a at the position overlapping the optical path of light emitted through each of the second end 41b and the fourth end 42b in a transparent plan view toward the first surface 2. In the present embodiment, the substrate 1 further includes the cutout 1a at the position overlapping the optical path of the light emitted through the sixth end 43b. The cutout 1a is a cut portion in the thickness direction of the first surface 2. The portion of the substrate 1 with the cutout 1a is thinner. In the structure according to the present embodiment, the cutout 1a allows light emitted from the core 4 to enter the lens 45 without being reflected from the first surface 2, thus reducing the decrease in the utilization efficiency of the light. This structure also reduces noise resulting from the light reflected from the first surface 2. The optical waveguide package 100 with this structure has high output and high image quality.

When, for example, the substrate 1 includes multiple dielectric layers stacked on one another, the portion corresponding to the cutout 1a in the dielectric layers on the first surface 2 may be removed in advance. The cutout 1a can also be formed by, for example, reactive ion etching, on the substrate 1 being a plate. Either process can be performed during manufacture of the substrate 1.

FIG. 8 is an enlarged plan view of a light emitter according to still another embodiment of the present disclosure, illustrating a portion adjacent to the lens 45. The components corresponding to those in the above embodiments are given the same reference numerals and will not be described repeatedly. In the present embodiment, the cladding 3 covers the second end 41b and the fourth end 42b. In the present embodiment, the cladding 3 further covers the sixth end 43b. In other words, the second end 41b of the first core 41 and the fourth end 42b of the second core 42 are not exposed, and are buried in the cladding 3. Among the interfaces between the cladding 3 and the core 4, the lateral interfaces each have an incident angle of light different from the incident angle of light at the interface between the second end 41b (the output end) and the cladding 3. The light is thus fully reflected at the lateral interfaces and is transmitted through the second end 41b without being reflected. The light transmitted through the second end 41b of the first core 41 travels through the cladding 3 and is emitted from the cladding 3 toward the lens 45. A part of the light traveling through the cladding 3 is reflected from the output face, but the reflected light is less likely to enter the first core 41 through the second end 41b. The same applies to a part of the light reflected from the lens 45. This reduces the likelihood of reflected light reaching the first element 10A after traveling through the first core 41, thus stabilizing the output of the first element 10A. This applies to the second core 42 and the fourth end 42b. This applies to the third core 43 and the sixth end 43b.

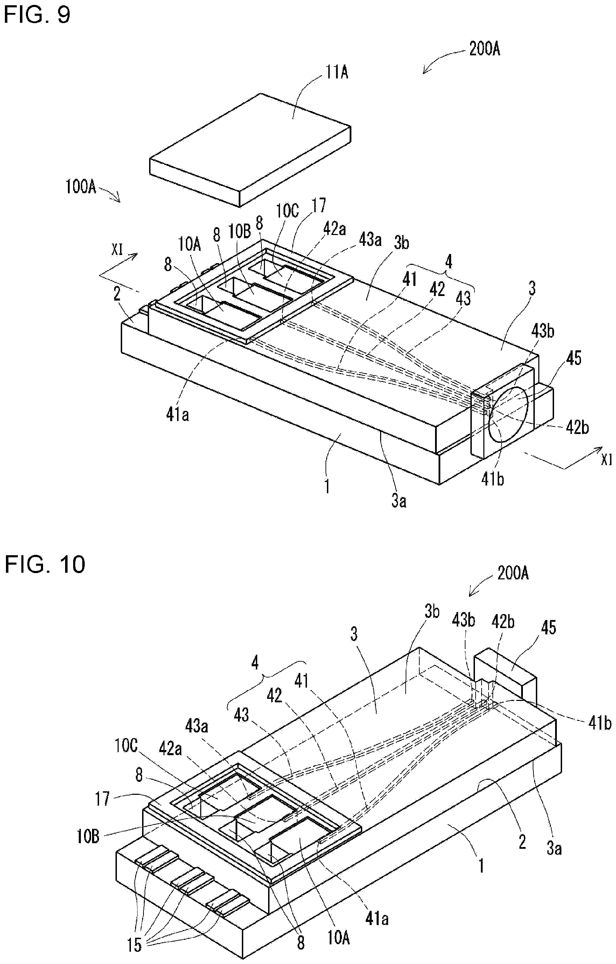

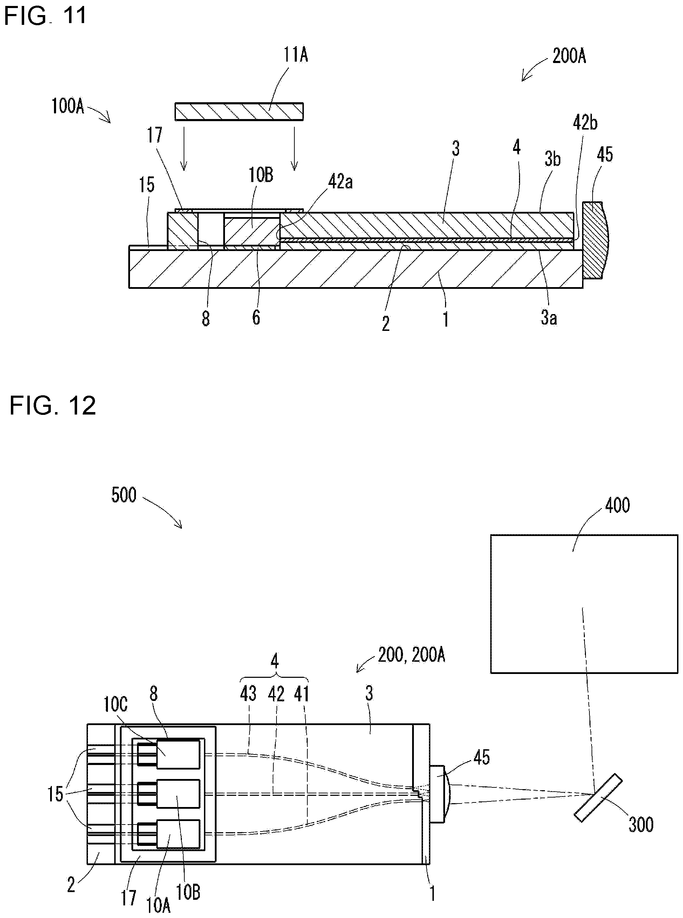

FIG. 9 is a development view of a light emitter 200A according to still another embodiment of the present disclosure. FIG. 10 is a perspective view of the light emitter 200A in FIG. 9 without illustrating a sealing lid 11A. FIG. 11 is a cross-sectional view of the light emitter 200A taken along section line XI-XI in FIG. 9. The components corresponding to those in the above embodiments are given the same reference numerals and will not be described repeatedly. In the above embodiments, the light-emitting elements 10A, 10B, and 10C include upper portions protruding from the through-holes 8. The protruding portions are covered with the sealing lid 11 being a box. In another embodiment, the through-holes 8 may each accommodate the entire light-emitting elements 10A, 10B, and 10C, and may be covered and sealed with the sealing lid 11A being a plate, as in an optical waveguide package 100A and in the light emitter 200A. This structure simplifies the sealing lid 11A. In the structure according to the present embodiment, the light-emitting elements 10A, 10B, and 10C can be connected, through flip-chip connection, to the external wires 15 on their bottom surfaces alone and can be connected to an external power supply circuit with the external wires 15.

In the optical waveguide package and the light emitter described with reference to FIGs. 1 to 11, the optical waveguide package 100 includes the through-holes 8, but is not limited to this structure. The optical waveguide package 100 may include recesses open on the third surface 3b, rather than the through-holes 8. The structure may be an external substrate with the element mount 6 to introduce light into the core 4. In this case, light may be introduced into the core 4 with optical fibers.

FIG. 12 is a schematic diagram of a projection system 500 according to an embodiment of the present disclosure. The projection system 500 includes the light emitter 200 and a screen 400. The screen 400 is located on the optical path of light condensed through the lens 45. The projection system 500 may include the light emitter 200A instead of the light emitter 200. In the present embodiment, the projection system further includes a scanning mirror 300. Light emitted from the light emitter 200 is reflected from the scanning mirror 300 and has its optical path redirected to be projected on the screen 400. For example, the reflection angle of the scanning mirror 300 is changed to cause light emitted from the light emitter 200 to be projected at a different position on the screen 400. A color image can be displayed on the screen 400 by continuously changing the position at which light is projected on the screen 400. With reduced chromatic aberration of light emitted from the light emitter 200, the image displayed on the screen 400 has high image quality with less blurring and less pixel deviation.

The scanning mirror 300 may change the reflection angle precisely and continuously in a short time. For example, a micromirror using micro electro mechanical systems (MEMS) may be used. The scanning mirror 300 may be, for example, a polygon scanner, a galvanometer scanner, or a resonant scanner, other than a micromirror. The screen 400 may be a diffuse screen, a retrograde screen, a reflective screen, or a rear screen. The screen 400 may also be the retina of an observer.

The first element 10A and the second element 10B are semiconductor lasers. Light is emitted from the light emitter 200 and projected on the screen 400 at the position of the beam waist of the semiconductor laser. As described above, the beam waist is the emitted light being condensed, and the beam projected on the screen 400 may have a minimum beam diameter. In other words, the beam waist may be located on the screen 400. This further improves the quality of the image on the screen 400.

In still another embodiment of the present disclosure, the light-emitting elements 10A, 10B, and 10C are not limited to light-emitting diodes (LEDs) but may be, for example, laser diodes (LDs) or vertical-cavity surface-emitting lasers (VCSELs). The light emitter 200 may include the light-emitting elements 10A, 10B, and 10C that are not directly mounted on the substrate 1. For example, light may be introduced through optical fibers from the respective light-emitting elements 10A, 10B, and 10C located apart from one another to enter the respective first core 41, second core 42, and third core 43.

The present disclosure may be implemented in the following forms.

In one or more embodiments of the present disclosure, an optical waveguide package includes a substrate including a first surface, a cladding on the first surface, a first core including a first end to receive light from a first element and a second end opposite to the first end, a second core including a third end to receive light from a second element having a wavelength of light different from a wavelength of light from the first element, and a fourth end opposite to the third end, and a lens on an optical path of light emitted through the second end and through the fourth end. The second end and the lens are at a first distance corresponding to the wavelength of the light from the first element. The fourth end and the lens are at a second distance corresponding to the wavelength of the light from the second element.

In one or more embodiments of the present disclosure, a light emitter includes the above optical waveguide package, a first element, and a second element.

In one or more embodiments of the present disclosure, a projection system includes the above light emitter, and a screen on an optical path of light condensed by the lens.

In one or more embodiments of the present disclosure, the optical waveguide package and the light emitter can emit light with reduced chromatic aberration. In one or more embodiments of the present disclosure, the projection system can improve the quality of the projection image.

Although embodiments of the present disclosure have been described in detail, the present disclosure is not limited to the embodiments described above, and may be changed or varied in various manners without departing from the spirit and scope of the present disclosure. The components described in the above embodiments may be entirely or partially combined as appropriate unless any contradiction arises.

### REFERENCE SIGNS

1 substrate
1a cutout
2 first surface
3 cladding
3a second surface
3b third surface
4 core
6 element mount
8 through-hole
10Afirst element
10B second element
10Cthird element
11 sealing lid
15 external wire
17 seal ring
20 holding substrate
41 first core
41a first end
41b second end
42 second core
42a third end
42b fourth end
43 third core
43a fifth end
43b sixth end
45 lens
100 optical waveguide package
200 light emitter
300 scanning mirror
400 screen
500 projection system
100, 100A optical waveguide package
200, 200A light emitter

## Claims

1. An optical waveguide package, comprising:
a substrate including a first surface;
a cladding on the first surface;
a first core including a first end to receive light from a first element and a second end opposite to the first end;
a second core including a third end to receive light from a second element and a fourth end opposite to the third end, the second element having a wavelength of light different from a wavelength of light from the first element; and
a lens on an optical path of light emitted through the second end and through the fourth end,
wherein the second end and the lens are at a first distance corresponding to the wavelength of the light from the first element, and
the fourth end and the lens are at a second distance corresponding to the wavelength of the light from the second element.

2. The optical waveguide package according to claim 1, wherein
at least one of an end face including the second end or an end face including the fourth end is inclined with respect to the optical path.

3. The optical waveguide package according to claim 1 or claim 2, wherein
the cladding includes a flat surface including the second end and the fourth end.

4. The optical waveguide package according to claim 3, wherein
the substrate includes a surface flush with the flat surface.

5. The optical waveguide package according to any one of claims 1 to 4, wherein
the substrate includes a cutout at a position overlapping the optical path in a transparent plan view toward the first surface.

6. The optical waveguide package according to any one of claims 1 to 3, wherein
the cladding covers the second end and the fourth end.

7. Alight emitter, comprising:
the optical waveguide package according to any one of claims 1 to 6;
a first element; and
a second element.

8. A projection system, comprising:
the light emitter according to claim 7; and
a screen on an optical path of light condensed by the lens.

9. The projection system according to claim 8, wherein
the first element and the second element are semiconductor lasers, and
the screen receives projection at a position of a beam waist of the semiconductor lasers.
